# EUROPÄISCHE PATENTSCHRIFT

(11) **EP 0 509 363 B1**
(45) Veröffentlichungstag und Bekanntmachung des Hinweises auf die Patenterteilung: **27.09.2000**
(21) Anmeldenummer: 92105941.6
(22) Anmeldetag: 06.04.1992
(51) Int. Cl.: H01L 29/73, H01L 29/10

(54) **Freilauf-Transistorschaltung**
Free-wheel transistor circuit
Circuit de transistor roue libre

(30) Priorität: 16.04.1991 DE 4112439
(43) Veröffentlichungstag der Anmeldung: 21.10.1992
(73) Patentinhaber: SIEMENS AKTIENGESELLSCHAFT, 80333 München (DE)
(72) Erfinder: Starke, Oskar, Dipl.-Ing., W-8000 München 50 (DE)

(56) Entgegenhaltungen:
- EP-A- 0 482 241
- DE-A- 3 910 526
- FR-A- 2 316 744
- FR-A- 2 377 706

## Beschreibung

Die Erfindung betrifft Schaltungsanordnung für eine Freilauf-Transistoranordnung, wie sie beispielsweise in Treiberschaltungen zum Ansteuern induktiver Lasten vorgesehen ist, um bei fehlender Ansteuerung der induktiven Last den Stromfluß in der Last zu gewährleisten und bei Abschalten der induktiven Last die in dieser enthaltene Energie abzubauen und die Verwendung einer solchen. Eine solche Schaltungsanordnung kann beispielsweise in getakteten High-Side-Spulentreibern eingesetzt werden, die z.B. zum Ansteuern von Relais vorgesehen sind. Ein getakteter High-Side-Spulentreiber ist eine Treiberschaltung, an deren Ausgang eine induktive Last angeschlossen wird, die gegen niedriges Potential geschaltet ist wobei dieser Ausgang der Treiberschaltung durch einen mit einem Taktsignal angesteuerten elektronischen Schalter periodisch an positives Versorgungspotential geschaltet wird.

Wenn eine solche Treiberschaltung monolithisch integriert ist, muß beim Abschalten der Last verhindert werden, daß das Ausgangspotential zu stark negativ bezüglich des Bezugspotentiales wird, um Störungen auf der integrierten Schaltung zu vermeiden. Hierzu kann durch eine Diode, die die Ausgangsspannung der Schaltungsanordnung begrenzt, der Stromfluß durch die induktive Last aufrecherhalten werden. Der Laststrom ist hierbei jedoch mit einer Welligkeit behaftet, die von der Durchlaßspannung der besagten, als Freilaufdiode geschalteten Diode abhängt. Die durch die Durchlaßspannung einer Freilaufdiode bedingte Welligkeit des Laststromes ist dann, wenn die Last eingeschaltet ist, unerwünscht. Beispielsweise zum sicheren Halten eines Relais, ist ein bestimmter mittlerer Laststrom erforderlich. Je größer die Welligkeit des Laststromes ist, umso größer ist die Stromaufnahme und somit die Leistungsaufnahme einer Treiberschaltung, um den gleichen mittleren Laststrom zur Verfügung zu stellen. Demzufolge führt eine geringe Welligkeit des Laststromes, die durch einen geringen Spannungsabfall über die Freilaufschaltungsanordnung bedingt ist, zu einer geringeren Verlustleistung der Treiberschaltung. Eine geringe Verlustleistung der Treiberschaltung ermöglicht es, diese in einem preiswerteren Gehäuse unterzubringen.

Wenn die Last bei fließendem Laststrom abgeschaltet werden soll, was beispielsweise durch Abschalten der Versorgungsspannung der Treiberschaltung erfolgen kann, so ist ein niedriger Spannungsabfall für die Freilaufschaltung ungünstig, da aufgrund der niedrigen Spannung die Energie in der induktiven Last nur langsam abgebaut wird, so daß ein Laststrom noch über längere Zeit fließt. Dadurch wird einerseits ein schnelles Abschalten verhindert, außerdem können beispielsweise bei Ansteuern eines Relais die Relaiskontakte schneller verschleißen. Beim Abschalten ist folglich ein hoher Spannungsabfall über die Freilaufschaltung von Vorteil, da die Energie in der induktiven Last sehr schnell abgebaut werden kann und damit ein schnelles Schalten ermöglicht wird.

Aus der EP 0 482 241 A1 ist eine monolitisch integrierbare bipolare Transistoranordnung bekannt, bei der die Emitterzone in einer wannenförmigen, epitaktischen Schicht eingebettet ist, die gegenüber der Emitterzone schwächer dotiert ist. Die Emitterzone ist von einer Basiszone vollständig umgeben, die ihrerseits vollständig von einem Kollektorgebiet anderen Leitungstyps umgeben ist. Bei dieser Anordnung ist der Grundriß der aktiven Basiszone eine maximale Fläche mit minimalem Umfang. Weitere monolitisch integrierbare bipolare Transistoranordnung sind aus der US 4,038,680 sowie aus der DE 39 10 526 A1 bekannt.

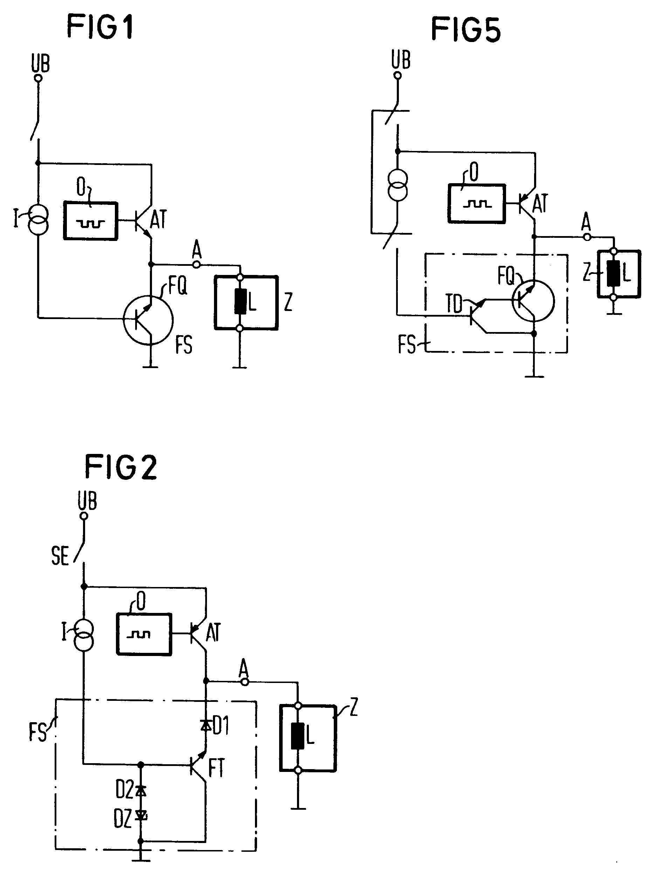

Am Beispiel eines getasteten High-Side-Spulentreibers mit Freilaufschaltung wird in Figur 2 eine Schaltungsanordnung beschrieben, bei der über die Freilautschaltung bei eingeschaltetem Treiber eine geringere Spannung abfällt als beiausgeschaltetem Treiber (zum Zeitpunkt des Ausschaltens, solange noch ein Laststrom fließt).

Figur 2 zeigt einen getasteten High-Side-Spulentreiber mit einem Ausgangstransistor AT, dessen Basisanschluß mit dem Ausgang eines Oszillators 0 verbunden ist und der von diesem Oszillator 0 mit einem periodischen Signal angesteuert wird. In Figur 2 ist als Ausgangstransistor AT ein pnp-Transistor dargestellt, die gleiche Schaltung ist prinzipiell jedoch auch mit einem npn-Transistor realisierbar. Der Emitteranschluß des Ausgangstransistors AT ist über einen Einschalter SE an positives Betriebspotential UB schaltbar. Der Kollektoranschluß des Ausgangstransistors AT bildet den Ausgang A der Treiberschaltung. An den Ausgang A der Treiberschaltung ist eine Anschlußklemme einer Last Z mit einer Induktivität L angeschlossen, deren andere Anschlußklemme gegen Bezugspotential Masse geschaltet ist. Ebenfalls an den Ausgang A der Treiberschaltung ist eine Freilauf-Transistoranordnung FS angeschlossen. Auch diese Freilauf-Transistoranordnung ist, ebenso wie der Ausgangstransistor AT, über den Einschalter SE an Betriebspotential UB schaltbar. Hierzu ist in der Figur 2 ein Anschluß einer Stromquelle I unmittelbar mit dem Emitteranschluß des Ausgangstransistors AT zusammengeschaltet. Die Freilauf-Transistoranordnung FS in Figur 2 besteht aus einem Freilauftransistor FT (hier einem npn-Transistor), dessen Emitteranschluß mit dem Kathodenanschluß einer Diode D1 verbunden ist. Der Anodenanschluß dieser Diode D1 ist mit dem Ausgang A der Treiberschaltung verbunden. Der Kollektoranschluß des Freilauftransistors FT ist an Bezugspotential Masse geschaltet. Der Basisanschluß des Freilauftransistors FT ist mit dem Anodenanschluß einer Diode D2 verbunden, deren Kathodenanschluß mit dem Kathodenanschluß einer Zenerdiode DZ verbunden ist, deren Anodenanschluß wiederum an das Bezugspotential Masse geschaltet ist. Außerdem ist der Basisanschluß des Freilauftransistors FT mit dem nicht an Betriebspotential UB schaltbaren Anschluß der genannten Stromquelle I verbunden.

Wenn in der Last Z ein Laststrom fließen soll, so wird der Einschalter SE geschlossen und der periodisch angesteuerte Ausgangstransistor AT schaltet in Abhängigkeit von seiner Ansteuerung das positive Betriebspotential UB periodisch an den Ausgang A der Treiberschaltung. Der Mittelwert des Laststromes ist hierbei unter anderem durch das Tastverhältnis des von dem Oszillator O bereitgestellten Ansteuersignales des Ausgangstransistors AT einstellbar.

Wenn der Schalter SE geschlossen ist, liefert die Stromquelle I einen konstanten Strom. Ist der Ausgangstransistor AT geschlossen und liegt somit der Ausgang A der Treiberschaltung auf hohem Potential, so fließt der Strom der Stromquelle I über die Basiskollektordiode des Freilauftransistors FT gegen Bezugspotential. Sperrt der Ausgangstransistor AT aufgrund seiner Ansteuerung, so wird das Potential am Ausgang A negativ bezüglich des Bezugspotentiales. Übersteigt hierbei die Spannung zwischen dem Basisanschluß des Freilauftransistors FT und dem Ausgang A der Treiberschaltung einen Wert, der durch die Durchlaßspannung der Diode D1 und die Basis-Emitterspannung des Freilauftransistors FT festgelegt wird, so wird der Freilauftransistor FT leitend und der Laststrom fließt, in gleicher Richtung wie vorher, vom Bezugspotential über den Freilauftransistor FT und die Diode D1. Hierbei unterschreitet das Potential am Ausgang A das Bezugspotential Masse um einen Wert, der durch die Durchlaßspannung der Diode D1 und die Sättigungsspannung des Transistors FT festgelegt wird.

Um den Laststrom abzuschalten, wird der Schalter SE geöffnet und somit der Kollektoranschluß des Ausgangstransistors AT von Betriebspotential getrennt und außerdem der Strom der Stromquelle I abgeschaltet, so daß der Freilauftransistor FT keinen Basisstrom mehr zur Verfügung hat. Wenn der Einschalter SE geöffnet wird, wird das Potential am Ausgang A negativ bezüglich Bezugspotential. Sobald die Spannung zwischen Bezugspotential und dem Ausgang A einen Wert erreicht, der durch die Durchlaßspannung der Diode D1, der Diode D2 und der Basis-Emitterdiode des Freilauftransistors FT sowie der Zenerspannung der Zenerdiode DZ festgelegt ist, dann fließt ein Strom vom Bezugspotential über die Zenerdiode DZ und die Diode D2 in die Basis des Freilauftransistors FT und dieser Freilauftransistor FT wird leitend, wobei über die Freilaufschaltung FS eine Spannung abfällt, die durch die Zenerdiode DZ sowie die Diodendurchgangsspannungen der übrigen pn-Übergänge der Schaltung festgelegt wird. Aufgrund dieses hohen Spannungsabfalles während der Entmagnetisierung der induktiven Last wird die in der induktiven Last enthaltene Energie schnell abgebaut.

Da der Freilauftransistor FT dann, wenn der Ausgang A der Treiberschaltung an positives Betriebspotential UB geschaltet ist, entgegengesetzt zur üblichen Stromflußrichtung dieses Freilauftransistors FT mit einer hohen Spannung beaufschlagt wird, ist die Diode D1 erforderlich, um einen Durchbruch im Bereich der Raumladungszone und eine Beeinflussung von in benachbarten Wannen der integrierten Schaltung befindlichen Schaltungsteilen zu vermeiden. Bei üblichen Anwendungsfällen ist hierbei als Diode D1 eine Doppelisolationsdiode mit hohem Flächenbedarf erforderlich.

Die Diode D2 soll verhindern, daß der Strom der Stromquelle I über die in Durchlaßrichtung gegen Bezugspotential geschaltete Zenerdiode DZ abfließt.

Aufgrund der Doppel-Iso-Diode D1 in der Freilauf-Transistoranordnung FS liegt bei geschlossenem Einschalter SE immer dann, wenn der Ansteuertransistor AT aufgrund entsprechender periodischer Ansteuerung sperrt, am Ausgang A eine Spannung an, die ca. 2 V unter dem Bezugspotential liegt. Der Spannungsabfall über die Freilaufschaltungseinrichtung in diesem Betriebszustand beeinflußt bei vorgegebenem mittleren Laststrom unmittelbar die Leistungsaufnahme der Spulentreiberschaltungsanordnung. Außerdem ist die beschriebene Freilauf-Transistoranordnung aufgrund der Doppelisolationsdiode sehr flächenintensiv.

Aufgabe der Erfindung ist das Bereitstellen Schaltungsanordnung für eine monolithisch integrierbare Freilauf-Transistoranordnung mit zwei unterschiedlichen, wählbaren Durchlaßspannungen, die bei gleicher Spannungsfestigkeit eine geringere Chipfläche benötigt und die eine kleinere minimale Durchlaßspannung aufweist.

Diese Aufgabe wird gelöst durch eine integrierte Schaltung mit den Merkmalen des Patentanspruchs 1.

Eine besonders günstige Ausgestaltungsform ist Gegenstand des Patentanspruches 2.

Patentanspruch 3 beschreibt die Verwendung einer solchen Freilauf-Transistoranordnung.

Die Erfindung wird nachfolgend anhand der Figuren 1, 3, 4 und 5 näher erläutert. Es zeigen:
- Figur 1: einen getakteten High-Side-Spulentreiber unter Verwendung einer Freilauf-Transistoranordnung FS,
- Figur 3: eine Draufsicht auf die Epitaxieschicht eines integrierbaren bipolaren Transistors FQ,
- Figur 4: einen Querschnitt durch einen integrierbaren bipolaren Transistor FQ nach Figur 3 längs der Linie A,
- Figur 5: die Verwendung einer besonders günstigen Ausgestaltungsform einer Freilauf-Transistoranordnung in einem getakteten High-Side-Spulentreiber.

In den Figuren sind gleiche Elemente mit gleichen Ziffern belegt.

Figur 1 zeigt einen getakteten High-Side-Spulentreiber mit einem Ausgangstransistor AT, dessen Basisanschluß mit dem Ausgang eines Oszillators O verbunden ist und der von diesem Oszillator O mit einem periodischen Signal angesteuert wird. In Figur 1 ist als Ausgangstransistor AT ein npn-Transistor dargestellt, die gleiche Schaltung ist prinzipiell bei entsprechender Anordnung jedoch auch mit einem pnp-Transistor realisierbar. Der Kollektoranschluß des AusgangstransistorS AT ist über einen Einschalter SE an positives Betriebspotential UB schaltbar. Der Emitteranschluß des Ausgangstransistors AT bildet den Ausgang A der Treiberschaltung. An den Ausgang A der Treiberschaltung ist eine Anschlußklemme einer Last Z mit einer Induktivität L angeschlossen, deren andere Anschlußklemme gegen Bezugspotential Masse geschaltet ist. Ebenfalls an den Ausgang A der Treiberschaltung ist eine Freilauf-Transistoranordnung FS angeschlossen. Auch diese Freilauf-Transistoranordnung ist, ebenso wie der Ausgangstransistor AT, über den Einschalter SE an Betriebspotential US schaltbar. Hierzu ist im Ausführungsbeispiel nach Figur 1 ein Anschluß einer Stromquelle I unmittelbar mit dem Kollektoranschluß des Ausgangstransistors AT zusammengeschaltet. Die Freilauf-Transistoranordnung FS in Figur 2 besteht aus einem Freilauftransistor FQ (hier einem npn-Transistor), dessen Emitteranschluß mit dem Ausgang A der Treiberschaltung verbunden ist. Der Kollektoranschluß des Freilauftransistors FQ ist an Bezugspotential Masse geschaltet. Der Basisanschluß des Freilauftransistors FQ ist mit dem nicht an Betriebspotential UB schaltbaren Anschluß der genannten Stromquelle I verbunden.

Wenn in der Last Z ein Laststrom fließen soll, so wird der Einschalter SE geschlossen und der periodisch angesteuerte Ausgangstransistor AT schaltet in Abhängigkeit von seiner Ansteuerung das positive Betriebspotential UB periodisch an den Ausgang A der Treiberschaltung. Der Mittelwert des Laststromes ist hierbei unter anderem durch das Tastverhältnis des von dem Oszillator O bereitgestellten Ansteuersignales des Ausgangstransistors AT einstellbar.

Wenn der Schalter SE geschlossen ist, liefert die Stromquelle I einen konstanten Strom. Ist der Ausgangstransistor AT geschlossen und liegt somit der Ausgang A der Treiberschaltung auf hohem Potential, so fließt der Strom der Stromquelle I über die Basiskollektordiode des Freilauftransistors FQ gegen Bezugspotential. Sperrt der Ausgangstransistor AT aufgrund seiner Ansteuerung, so wird das Potential am Ausgang A negativ bezüglich des Bezugspotentiales. Übersteigt hierbei die Spannung zwischen dem Basisanschluß des Freilauftransistors FQ und dem Ausgang A der Treiberschaltung einen Wert, der durch die Basis-Emitterspannung des Freilauftransistors FQ festgelegt wird, so wird der Freilauftransistor FQ leitend und der Laststrom fließt, in gleicher Richtung wie vorher, vom Bezugspotential über den Freilauftransistor FQ. Hierbei unterschreitet das Potential am Ausgang A das Bezugspotential Masse um einen Wert, der durch die Sättigungsspannung des Transistors FQ festgelegt wird.

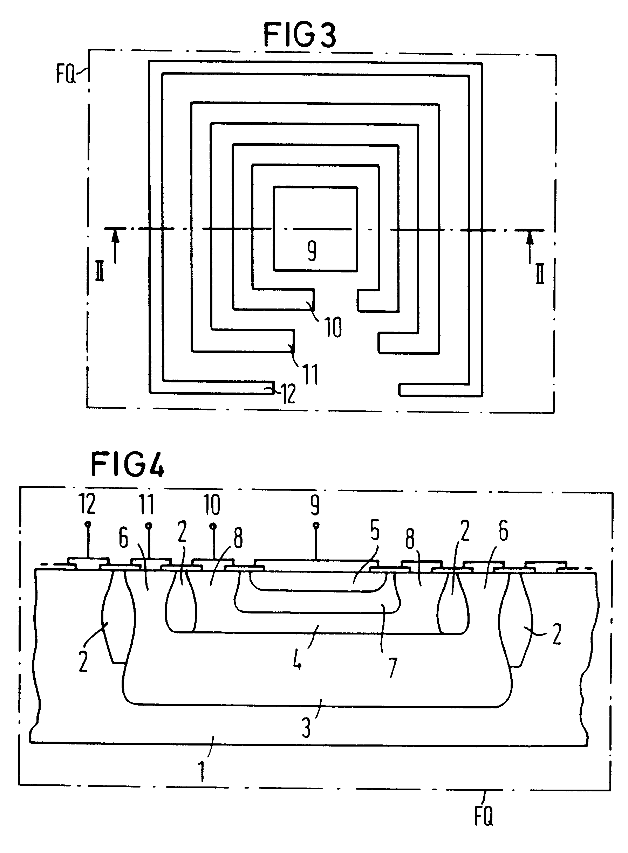

Um den Laststrom abzuschalten, wird der Schalter SE geöffnet und somit der Kollektoranschluß des Ausgangstransistors AT von Betriebspotential getrennt und außerdem der Strom der Stromquelle I abgeschaltet, so daß der Freilauftransistor FT keinen Basisstrom mehr zur Verfügung hat. Wenn der Einschalter SE geöffnet wird, wird das Potential am Ausgang A negativ bezüglich Bezugspotential. Sobald die Spannung zwischen Bezugspotential und dem Ausgang A einen Wert erreicht, der durch die Durchlaßspannung der Basis-Emitterdiode des Freilauftransistors FQ sowie die Zenerspannung der durch die Buried-layer-Zone (3 aus Figur 4) und die aktive Basiszone (4 aus Figur 4) gebildeten Zenerdiode festgelegt ist, dann fließt ein Strom vom Bezugspotential über den Kollektoranschluß (11 aus Figur 4) und die Buried-layer-Zone (6, 3 aus Figur 4) in die Basiszone des Freilauftransistors FQ und dieser Freilauftransistor FQ wird leitend, wobei über die Freilaufschaltung FS eine Spannung abfällt, die durch die Zenerspannung zwischen Buried-layer-Zone und Basiszone sowie die Sättigungsspannung des Freilauf-Transistors FQ festgelegt wird. Aufgrund dieses hohen Spannungsabfalles während der Entmagnetisierung der induktiven Last wird die in der induktiven Last enthaltene Energie schnell abgebaut.

Da der Freilauftransistor FQ aufgrund ihres Aufbaus entgegengesetzt zur üblichen Stromflußrichtung dieses Freilauf-Transistors FQ mit einer relativ hohen Spannung beaufschlagbar ist, ist eine Diode D1, wie in Figur 2 gezeigt, nicht erforderlich.

Nach Figur 3 ist eine Freilauf-Transistoranordnung FQ derart ausgebildet, daß ein Emitterkontakt 9 ringförmig von dem Basiskontakt 10 umgeben ist. Der Basiskontakt 10 kann dabei auf der Kontaktierungsfläche eine Öffnung aufweisen, durch die eventuelle Anschlüsse zum Emitterkontakt geführt werden können. Der Basiskontakt 10 ist wiederum im Abstand von dem Kolletorkontakt 11 umgeben. Auch diese kann wie der Basiskontakt 10 eine Öffnung zur Durchführung von Anschlüssen aufweisen. Letztendlich umschließt der Substratanschlußzone 12 den Transistor. Auch diese kann wieder eine Öffnung zur Durchführung von Anschlüssen aufweisen Im Halbleiterkristall ist die Emitterzone vollständig von der Basiszone umgeben. Die Basiszone hat vorzugsweise einen Grundriß, dessen Fläche maximal und dessen Umfang minimal ist.

Der Aufbau einer integrierbaren Freilauf-Transistoranordnung wird anhand von Figur 4 deutlich. In einem Substrat 1, das z.B. aus einem Halbleiter, insbesondere Silizium bestehen kann, ist ein Buried-layer-Bereich 3 eindotiert. Ebenfalls im Substrat 1 ist eine untere Isolationsschicht 4 eindotiert, die im Bereich des Buried-layer-Bereichs 3 diesem überlagert ist. Auf der Oberfläche ist eine ganzflächige Epitaxieschicht 2 abgeschieden. Kollektor-Tiefdiffusionsbereiche 6 sind von der Oberfläche so in die Epitaxieschicht 2 eingebracht, daß sie bis in die Buried-layer-Schicht 3 hineinragen. Oberhalb der Buried-layer-Schicht 3 zwischen den Kollektor-Tiefdiffusionsbereichen 6 befindet sich der Basisbereich. Dieser wird durch obere Isolationsbereiche 8 gebildet, die von der Oberfläche so in die Epitaxieschicht 2 eingebracht sind, daß sie bis in die untere Isolationsschicht 4 hineinragen.

Die untere Isolationsschicht 4, angrenzend an den Buried-layer-Bereich 3 bildet die aktive Basiszone, die in die aktive Basiszone hineinragende obere Isolationsschicht 8 die kontaktierende Basiszone. Innerhalb der verbleibenden, vollkommen von der Basiszone umschlossenen Epitaxiewanne 7 ist die bis zur Oberfläche reichende Emitterzone 5 eingebettet. Der Transistor wird von seiner Umgebung isoliert durch den außerhalb des Buried-layer-Bereich 3 angeordneten p-Ring, bestehend aus den beiden Isolationsschichten 4 und 8. Die Emitterzone 5 ist mit der Emitterleitbahn 9 kontaktiert. Desgleichen ist die Basiszone mit der Basisleitbahn 10 und der Kollektorzone mit der Kollektorleitbahn 11 kontaktiert. Daß den Transistor umgebende Substrat ist ebenfalls über einer Substratleitbahn 12 kontaktiert.

Für eine Freilauf-Transistoranordnung in Form eines npn-Transistors können folgende Leitungstypen verwendet werden. Das Halbleitersubstrat 1 und die kontaktierende Basiszone 8 sind vom p⁺- und die aktive Basiszone 4 vom p-Leitungstyp. Die epitaktische Schicht 2,7 ist vom n⁻- und die Emitterzone 5, der Buried-layer 3 und die Kollektorzone 6 vom n⁺-Leitungstyp.

Durch die gewählte Struktur weist die Kollektorseite des inversen Transistors (= Emitterzone) eine ausreichende Raumladungszone auf. Dies wird dadurch gewährleistet, daß zwischen dem hochdotierten Emittergebiet und der Basiszone, sowohl lateral als auch vertikal ein ausreichend großes niedrig dotiertes Epitaxiegebiet vorhanden ist. Die Kollektordurchbruchsspannung wird auf diese Weise gegenüber üblichen Transistoren deutlich heraufgesetzt. Durch das Driftfeld der aktiven Basiszone wird außerdem die Stromverstärkung des inversen Transistors günstig beeinflußt.

Im Vergleich zu einem üblichen npn-Transistor mit einem Substratstromanteil von nahezu 100 % des Kollektorstroms bei Verpolung, hat die Transistorstruktur einen Substratstromanteil von 0,1 % des Kollektorstroms bis zu einem Verpolstrom von 100 mA. Dabei fließt etwa 1 % des Substratstroms in die Nachbarwannne. Außerdem sind zur Vermeidung der Aktivierung parasitärer Strukturen keine zusätzlichen Freilaufdioden notwendig. Die erfindungsgemäße Transistoranordnung kann in jeder integrierten Schaltung verwendet werden.

Durch die Verwendung einer bipolaren Technologie mit Doppelisolation und unter Berücksichtigung ausreichend großer Abstände zwischen Emitterzone 5 und den beiden Isolationsschichten 4 und 8 wird außerdem eine hohe Durchbruchsspannung für den Inversbetrieb gewährleistet.

Figur 5 zeigt einen getakteten High-Side-Spulentreiber gemäß Figur 2, bei dem als Freilauf-Transistoransordnung FS eine Darlington-Stufe vorgesehen ist, die aus einem Transistor TD und einem als Ausgangstransistor vorgesehenen Freilauf-Transistor FQ gemäß Figuren 3 und 4 gebildet wird. Dabei ist der Basisanschluß des Transistors TD an die Stromquelle I schaltbar, der Emitteranschluß des Transistors TD mit dem Basisanschluß des Transistors FQ verbunden und der Kollektoranschluß des Transistors TD mit dem Kollektoranschluß des Transistors FQ zusammengeschaltet. Der Kollektoranschluß des Freilauf-Transistors FQ ist gegen Bezugspotential Masse geschaltet und der Emitteranschluß des Freilauf-Transistors FQ ist an den Ausgang A der High-Side-Spulentreiberschaltung geschaltet.

Wenn in der Last Z ein Laststrom fließen soll, wird über die Stromquelle I dem Transistor TD ein Basisstrom eingeprägt. Aufgrund der hohen Stromverstärkung der Darlington-Stufe TD, FQ ist hierzu ein geringerer Strom erforderlich als bei der Freilauf-Transistoranordnung FS, die in Figur 1 beschrieben ist.

Wenn der Laststrom abgeschaltet werden soll, wird die Stromquelle I abgeschaltet und, da der Zener-Durchbruch innerhalb des Freilauf-Transistors FQ stattfindet, verhält sich die Freilauf-Transistoranordnung FS nach Figur 5 in diesem Betriebsfall genauso wie die Freilauf-Transistoranordnung FS gemäß Figur 1.

## Patentansprüche

1. Schaltungsanordnung mit einer monolithisch integrierbaren Ereilauf-Transistoranordnung (FS),
(a) deren Durchlaßspannung steuerbar zwei unterschiedliche Werte annimmt und deren Laststrecke in Parallelschaltung zu einer Last (Z) geschaltet ist,
(b) mit ersten Ansteuermitteln (O), die eine Schalteinrichtung (AT) ansteuern, wobei die Laststrecke der Schalteinrichtung (AT) in Reihe zu der Parallelschaltung geschaltet ist,
(c) mit einer Ereilauf-Transistorstruktur (FQ),
- bei der auf einem Halbleiterkörper (1) eines ersten Leitungstyps eine bis zur Oberfläche des Halbleiterkörpers (1) reichende epitaktische Schicht (2) von einem zweiten Leitungstyp vorgesehen ist,
- bei der zwischen der epitaktischen Schicht (2) und dem Halbleiterkörper (1) eine vergrabene Schicht-Zone (Buried-Layer-Zone) (3) vom zweiten Leitungstyp vorgesehen ist,
- bei der zwischen der Buried-Layer-Zone (3) und der Oberfläche des Halbleiterkörpers (1) eine aktive Basiszone (4) vom ersten Leitungstyp vorgeshen ist,
- bei der eine wannenförmige, in der aktiven Basiszone (4) eingebettete Emitterzone (5) vom zweiten Leitungstyp vorgeshen ist,
- bei der eine im Abstand von der aktiven Basiszone (4) die aktive Basiszone (4) ringförmige umschließende Kollektorzone (6) vom zweiten Leitungstyp vorgesehen ist, die von der Oberfläche bis in die vergrabene Schicht-Zone (Buried-layer-Zone) (3) hinein reicht,
- bei der die Emitterzone (5) in eine wannenförmige epitaktische Schicht (7) vom zweiten Leitungstyp eingebettet ist, die gegenüber der Emitterzone (5) eine niedrigere Dotierungskonzentration aufweist,
- bei der die wannenförmige epitaktische Schicht (7) von einer kontaktierenden Basiszone (8) vom ersten Leitungstyp ringförmig umgeben ist, die bis zur aktiven Basiszone (4) reicht, wobei die aktive Basiszone (4) zwischen wannenförmiger epitaktischer Schicht (7) und vergrabener Schicht-Zone (Buried-Layer-Zone) (3) angordnet ist,
(d) mit zweiten Ansteuermitteln (I, TD),
- die in Abhängigkeit von einem ersten Ansteuersignal der ersten Ansteuermittel (O) ein zweites Ansteuersignal erzeugen, das einem Steueranschluß der Freilauf-Transistorstruktur (FQ) zugeführt wird,
- wobei ein Beaufschlagen der Ereilauf-Transistorstruktur (FQ) mit dem zweiten Ansteuersignal eine niedrige Durchlaßspannung der Ereilauf-Transistoranordnung (ES) bewirkt.

2. Schaltungsanordnung nach Anspruch 1,
**dadurch gekennzeichnet**,
daß der Freilauf-Transistor (FQ) gemeinsam mit einem weiteren Transistor (TD) zu einer Darlington-Schaltung zusammengeschaltet ist, wobei der Ereilauftransistor (FQ) den Ausgangstransistor dieser Darlington-Schaltung bildet.

3. High-Side-Spulentreiberschaltung mit einer Schaltungsanordnung mit einer monolithisch integrierbaren Ereilauf-Transistoranordnung (ES) nach einem der Ansprüche 1 bis 2.

## Claims

1. Circuit arrangement with a monolithically integrable freewheeling transistor arrangement (FS),
(a) whose forward voltage assumes, in a controllable manner, two different values and whose load path is connected in a parallel circuit with a load (Z),
(b) with first drive means (O), which drive a switching device (AT), the load path of the switching device (AT) being connected in series with the parallel circuit
(c) with a freewheeling transistor structure (FQ),
- in which, on a semiconductor body (1) of a first conduction type, an epitaxial layer (2) of a second conduction type is provided, the said epitaxial layer extending as far as the surface of the semiconductor body (1),
- in which a buried layer zone (3) of the second conduction type is provided between the epitaxial layer (2) and the semiconductor body (1),
- in which an active base zone (4) of the first conduction type is provided between the buried layer zone (3) and the surface of the semiconductor body (1),
- in which an emitter zone (5) of the second conduction type is provided which is in the form of a well and is embedded in the active base zone (4),
- in which a collector zone (6) of the second conduction type is provided which annularly encloses the active base zone (4) at a distance from the active base zone (4) and extends from the surface down into the buried layer zone (3),
- in which the emitter zone (5) is embedded in an epitaxial layer (7) of the second conduction type which is in the form of a well and has a lower doping concentration than the emitter zone (5),
- in which the epitaxial layer (7) in the form of a well is annularly surrounded by a contact-making base zone (8) of the first conduction type which extends as far as the active base zone (4), the active base zone (4) being arranged between the epitaxial layer (7) in the form of a well and the buried layer zone (3),
(d) with second drive means (I, TD),
- which generate a second drive signal as a function of a first drive signal of the first drive means (O), which second drive signal is fed to a control terminal of the freewheeling transistor structure (FQ),
- application of the second drive signal to the freewheeling transistor structure (FQ) effecting a low forward voltage of the freewheeling transistor arrangement (FS).

2. Circuit arrangement according to Claim 1, characterized
in that the freewheeling transistor (FQ) is interconnected together with a further transistor (TD) to form a Darlington circuit, the freewheeling transistor (FQ) forming the output transistor of this Darlington circuit.

3. High-side coil driver circuit with a circuit arrangement with a monolithically integrable freewheeling transistor arrangement (FS) according to one of Claims 1 to 2.

## Revendications

1. Circuit comprenant un circuit de transistor à roue libre (FS) monolithiquement intégrable,
(a) dont la tension à l'état passant est commandable de manière à prendre deux valeurs différentes et dont la ligne de charge est montée en parallèle à une charge (Z),
(b) avec des premiers moyens de commande (O), qui commandent un dispositif de commutation (AT), la ligne de charge du dispositif de commutation (AT) étant montée en série avec le montage en parallèle,
(c) avec une structure de transistor à roue libre (FQ),
- laquelle comporte sur un corps semi-conducteur (1) d'un premier type de conductivité une couche épitaxiale (2) d'un deuxième type de conductivité s'étendant jusqu'à la surface du corps semi-conducteur (1),
- laquelle comporte entre la couche épitaxiale (2) et le corps semi-conducteur (1) une zone de couche enfouie (buried-layer-zone) (3) du deuxième type de conductivité,
- laquelle comporte entre la buried-layer-zone (3) et la surface du corps semi-conducteur (1) une zone de base active (4) du premier type de conductivité,
- laquelle comporte une zone d'émetteur (5) en forme de cuvette enfouie dans la zone de base active (4) du deuxième type de conductivité,
- laquelle comporte une zone de collecteur (6) entourant la zone de base active (4) en anneau à distance de la zone de base active (4) du deuxième type de conductivité, qui s'étend de la surface jusque dans la zone de couche enfouie (buried-layer-zone) (3),
- dans laquelle la zone d'émetteur (5) est enfouie dans une couche épitaxiale (7) en forme de cuvette du deuxième type de conductivité, qui présente une concentration en dopant plus faible par rapport à la zone d'émetteur (5),
- dans laquelle la couche épitaxiale (7) en forme de cuvette est entourée en anneau d'une zone de base (8) de contact du premier type de conductivité, qui s'étend jusqu'à la zone de base active (4), la zone de base active (4) étant disposée entre la couche épitaxiale (7) en forme de cuvette et la zone de couche enfouie (buried-layer-zone) (3),
(d) avec des deuxièmes moyens de commande (I, TD),
- qui génèrent en fonction d'un premier signal de commande des premiers moyens de commande (O), un deuxième signal de commande qui est amené à une borne de commande de la structure de transistor à roue libre (FQ),
- une application du deuxième signal de commande à la structure de transistor à roue libre (FQ) induisant une tension à l'état passant plus faible du circuit de transistor à roue libre (FS).

2. Circuit selon la revendication 1, caractérisé en ce que le transistor à roue libre (FQ) et un autre transistor (TD) sont interconnectés pour former ensemble un circuit Darlington, le transistor à roue libre (FQ) formant le transistor de sortie de ce circuit Darlington.

3. Circuit d'attaque de bobine high-side doté d'un circuit comprenant un circuit de transistor à roue libre (FS) monolithiquement intégrable selon l'une des revendications 1 à 2.
